# EUROPEAN PATENT APPLICATION

(11) **EP 4 839 032 A1**
(43) Date of publication of application: **11.11.2026**
(21) Application number: 25768676.6
(22) Date of filing: 04.02.2025
(51) Int. Cl.: H05K 3/46

(54) **ELECTRONIC DEVICE COMPRISING PRINTED CIRCUIT BOARD**

(30) Priority: 06.03.2024 KR 20240032210
(71) Applicant: Samsung Electronics Co., Ltd., Suwon-si, Gyeonggi-do 16677 (KR)
(72) Inventor: PARK, Sungwu, Suwon-si, Gyeonggi-do 16677 (KR); LEE, Sangmin, Suwon-si, Gyeonggi-do 16677 (KR); HAN, Junhee, Suwon-si, Gyeonggi-do 16677 (KR); KIM, Jeongseob, Suwon-si, Gyeonggi-do 16677 (KR)
(74) Representative: Nederlandsch Octrooibureau
(86) International application number: PCT/KR2025/099238
(87) International publication number: WO 2025/188121

(57) **Abstract**

An electronic device, according to one embodiment of the present disclosure, may comprise: a first printed circuit board comprising a first surface, a second surface which is the surface opposite the first surface, and a first conductive pad formed on the first surface; a second printed circuit board comprising a third surface of which at least a portion faces the second surface, a fourth surface which is the surface opposite the third surface, and a second conductive pad formed on the third surface; a power management circuit disposed on the first surface of the first printed circuit board and electrically connected to the first conductive pad; a power supply circuit disposed on at least one surface among the third surface and the fourth surface of the second printed circuit board and electrically connected to the second conductive pad; a conductive plate contacting the first conductive pad at a first end and contacting the second conductive pad at a second end; and an insulating member disposed on at least one portion of the conductive plate.

## Description

### [Technical Field]

The disclosure relates to an electronic device including a printed circuit board.

### [Background Art]

An electronic device may include a multilayer printed circuit board formed of a plurality of printed circuit boards. The multilayer printed circuit board may be formed by bonding the plurality of printed circuit boards. The electronic device may secure a space for arranging electronic components and wiring even in a limited space by using the multilayer printed circuit board. In the multilayer printed circuit board, one printed circuit board may be bonded to another adjacent printed circuit board by soldering.

The above-described information may be provided as related art for the purpose of assisting in understanding the disclosure. None of the foregoing might be asserted as prior art relevant to the disclosure or used for determination on prior art.

### [Disclosure of Invention]

### [Solution to Problem]

An electronic device according to an embodiment of the disclosure may include a first printed circuit board, a second printed circuit board, a power management circuit, a power supply circuit, a conductive plate, and an insulating member.

In an embodiment, the first printed circuit board may include a first surface, a second surface opposite to the first surface, and a first conductive pad formed on the first surface.

In an embodiment, the second printed circuit board may include a third surface, at least a portion of which faces the second surface, a fourth surface opposite to the third surface, and a second conductive pad formed on the third surface.

In an embodiment, the power management circuit may be disposed on the first surface of the first printed circuit board and may be electrically connected to the first conductive pad.

In an embodiment, the power supply circuit may be disposed on at least one of the third surface and the fourth surface of the second printed circuit board and may be electrically connected to the second conductive pad.

In an embodiment, the conductive plate may be in contact with the first conductive pad at a first end and may be in contact with the second conductive pad at a second end.

In an embodiment, the insulating member may be disposed on at least a portion of the conductive plate.

An electronic device according to an embodiment of the disclosure may include a first printed circuit board, a second printed circuit board, a conductive plate, and an insulating member.

### [Brief Description of Drawings]

FIG. 1 is a block diagram of an electronic device in a network environment according to an embodiment.
FIGS. 2A, 2B, and 2C are views illustrating an electronic device according to an embodiment of the disclosure.
FIG. 3 is a view illustrating an electronic device according to an embodiment of the disclosure.
FIGS. 4A and 4B are views respectively illustrating a conductive pad and a dummy pad according to an embodiment of the disclosure.
FIGS. 5A, 5B, and 5C are views illustrating an electronic device according to an embodiment of the disclosure.
FIG. 6 is a view illustrating an electronic device including a conductive plate according to an embodiment of the disclosure.
FIGS. 7A and 7B are views each illustrating a conductive plate according to an embodiment of the disclosure.
FIG. 8 is a view illustrating an electronic device according to an embodiment of the disclosure.
FIGS. 9A and 9B are views illustrating an electronic device according to an embodiment of the disclosure.
FIGS. 10A and 10B are views illustrating an electronic device according to an embodiment of the disclosure.

### [Mode for the Invention]

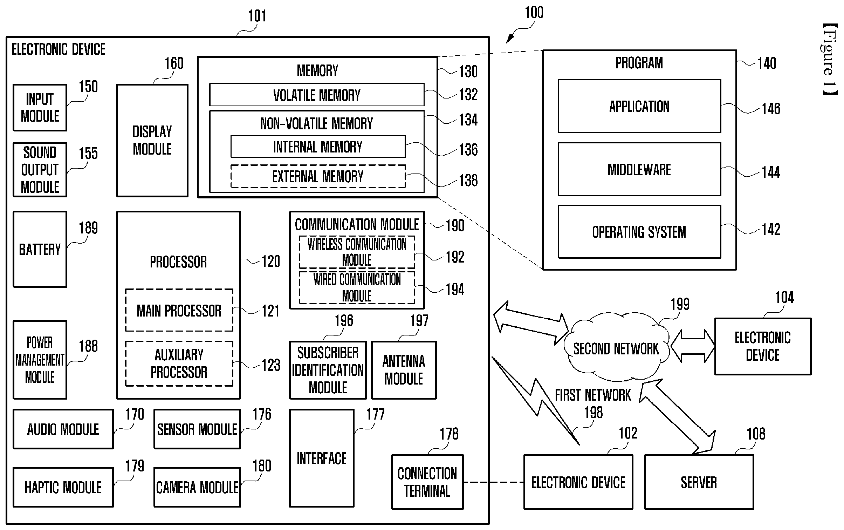

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

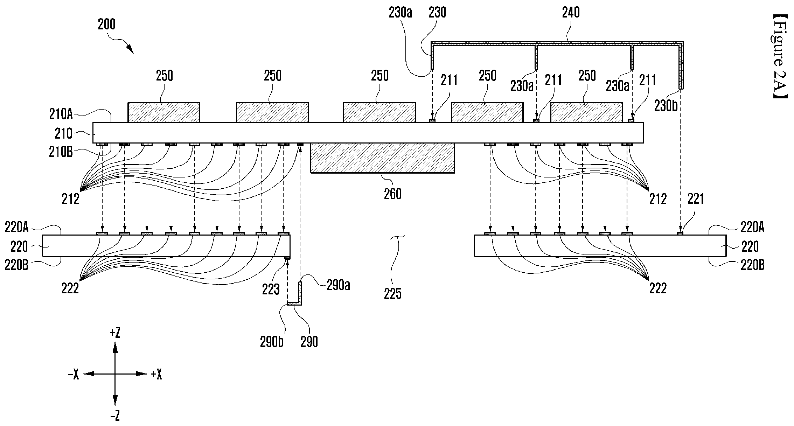

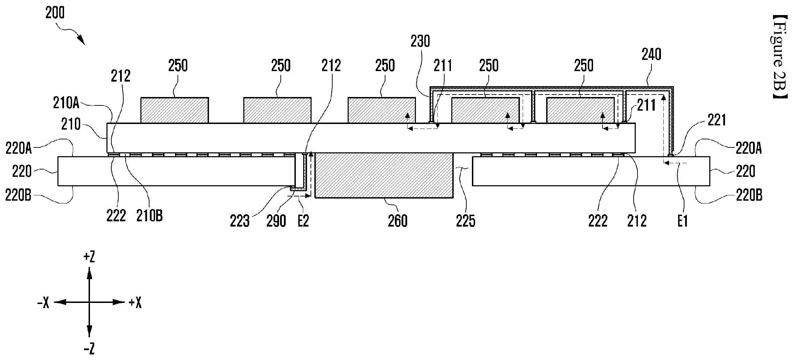

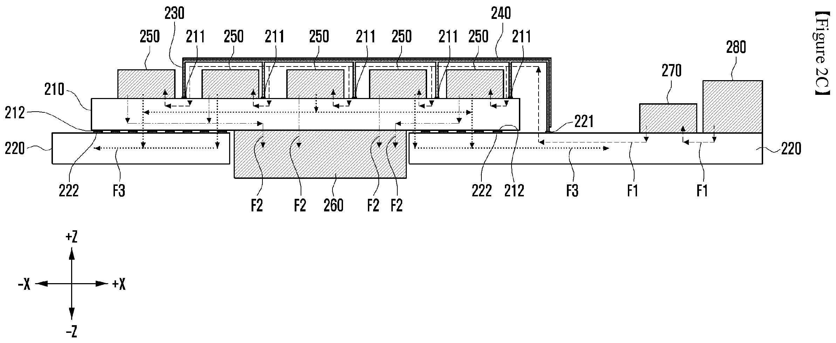

FIGS. 2A, 2B, and 2C are views illustrating an electronic device 200 according to an embodiment of the disclosure.

FIG. 2A is a view illustrating a first printed circuit board 210 and a second printed circuit board 220 according to an embodiment. FIG. 2B is a view illustrating a state in which the first printed circuit board 210 according to an embodiment is disposed on the second printed circuit board 220. FIG. 2C is a view illustrating an electronic device 200 including a third electronic component 270.

In describing the electronic device 200 according to an embodiment of the disclosure, the height direction of the electronic device 200 may refer to the Z-axis direction. The length direction of the electronic device 200 may refer to the X-axis direction.

The electronic device 200 according to an embodiment of the disclosure may include the first printed circuit board 210, the second printed circuit board 220, a first conductive plate 230, an insulating member 240, first electronic components 250, a second electronic component 260, the third electronic component 270, a fourth electronic component 280, and/or a second conductive plate 290.

The dashed arrows illustrated in FIG. 2A may indicate directions in which components of the electronic device 200 are moved and disposed. For example, the first printed circuit board 210, the first conductive plate 230, and the second conductive plate 290 may be moved and disposed along the directions illustrated by the dashed arrows.

In an embodiment, the first printed circuit board 210 may include a first surface 210A, a second surface 210B, and/or first conductive pads 211.

In an embodiment, the first surface 210A may be a surface of the first printed circuit board 210 oriented in the positive Z-axis direction. The second surface 210B may be a surface opposite to the first surface 210A. For example, the second surface 210B may be a surface of the first printed circuit board 210 oriented in the negative Z-axis direction.

In an embodiment, the first conductive pads 211 may be formed on the first surface 210A of the first printed circuit board 210. The first conductive pads 211 may be contact points electrically connected to other components of the electronic device 200.

In an embodiment, the second printed circuit board 220 may include a third surface 220A, a fourth surface 220B, and/or second conductive pads 221.

In an embodiment, the third surface 220A may be a surface of the second printed circuit board 220 oriented in the positive Z-axis direction. The fourth surface 220B may be a surface opposite to the third surface 220A. For example, the fourth surface 220B may be a surface of the second printed circuit board 220 oriented in the negative Z-axis direction.

In an embodiment, the second conductive pads 221 may be formed on the third surface 220A of the second printed circuit board 220. The second conductive pads 221 may be contact points electrically connected to other components of the electronic device 200.

In an embodiment, the first conductive plate 230 may serve to electrically connect the first printed circuit board 210 and the second printed circuit board 220.

In an embodiment, the first conductive plate 230 may be in contact with the first conductive pads 211 at first ends 230a and may be in contact with the second conductive pads 221 at a second end 230b.

In an embodiment, the first conductive plate 230 may include a conductive material. For example, the first conductive plate 230 may include stainless steel (STS).

In an embodiment, the insulating member 240 may be disposed on at least a portion of the first conductive plate 230. In an embodiment, the insulating member 240 may include an insulating material.

In an embodiment, the insulating member 240 may serve to prevent the first conductive plate 230 from being electrically exposed. For example, the insulating member 240 may serve to prevent or reduce an electrical shock that may be applied to the first conductive plate 230.

In an embodiment, the first electronic components 250 may be disposed on the first surface 210A of the first printed circuit board 210. The first electronic components 250 may be electrically connected to the first conductive pads 211.

In an embodiment, the second electronic component 260 may be disposed on the second surface 210B of the first printed circuit board 210.

In an embodiment, the first electronic components 250 may include a power management circuit. For example, the first electronic components 250 may include a power management integrated circuit (PMIC) configured to distribute and supply driving power required for each component of the electronic device 200.

In an embodiment, the second electronic component 260 may include a processor. For example, the second electronic component 260 may include an application processor configured to control at least one other component (e.g., a hardware component or a software component) of the electronic device 200.

In an embodiment, the first printed circuit board 210 may include third conductive pads 212. The third conductive pads 212 may be formed on the second surface 210B of the first printed circuit board 210.

In an embodiment, the second printed circuit board 220 may include fourth conductive pads 222 and/or a fifth conductive pad 223. The fourth conductive pads 222 may be formed on the third surface 220A of the second printed circuit board 220. The fifth conductive pad 223 may be formed on the fourth surface 220B of the second printed circuit board 220.

Referring to FIGS. 2A and 2B, the first printed circuit board 210 may be disposed on the second printed circuit board 220. The first printed circuit board 210 may be disposed on the second printed circuit board 220 such that the third conductive pads 212 come into contact with the fourth conductive pads 222.

Referring to FIGS. 2A and 2B, the third conductive pads 212 may be bonded to the fourth conductive pads 222. For example, the third conductive pads 212 may be bonded to the fourth conductive pads 222 by soldering. The third conductive pads 212 may be bonded to the fourth conductive pads 222 and may be electrically connected to the fourth conductive pads 222.

In an embodiment, the second conductive plate 290 may serve to electrically connect the first printed circuit board 210 and the second printed circuit board 220.

In an embodiment, the second conductive plate 290 may be in contact with a third conductive pad 212 at one end 290a and may be in contact with the fifth conductive pad 223 at an opposite end 290b.

In an embodiment, the second conductive plate 290 may include a conductive material. For example, the second conductive plate 290 may include stainless steel (STS).

Referring to FIG. 2B, a first power flow E1 from an upper surface of the second printed circuit board 220 (e.g., the third surface 220A) toward an upper surface of the first printed circuit board 210 (e.g., the first surface 210A) may be formed along the first conductive plate 230.

Referring to FIG. 2B, a second power flow E2 from a lower surface of the second printed circuit board 220 (e.g., the fourth surface 220B) toward a lower surface of the first printed circuit board 210 (e.g., the second surface 210B) may be formed along the second conductive plate 290.

In an embodiment, the second printed circuit board 220 may include an opening 225 in at least a portion thereof.

In an embodiment, at least a portion of the second electronic component 260 may be inserted into the opening 225 of the second printed circuit board 220.

In an embodiment, the third electronic component and the fourth electronic component 280 may be disposed on the second printed circuit board 220.

In an embodiment, the third electronic component 270 and the fourth electronic component 280 may be disposed on at least one of the third surface 220A and the fourth surface 220B of the second printed circuit board 220. For example, referring to FIG. 2C, the third electronic component 270 and the fourth electronic component 280 may be disposed on the third surface 220A of the second printed circuit board 220.

In an embodiment, the third electronic component 270 and the fourth electronic component 280 may be electrically connected to each other.

In an embodiment, the third electronic component 270 may include a power supply circuit. For example, the third electronic component 270 may include a power supply circuit configured to transmit power supplied from a battery 189 (see FIG. 1) to the first electronic components 250. In an embodiment, the third electronic component 270 may include a power management integrated circuit (PMIC) configured to supply power to the first electronic component 250.

In an embodiment, the fourth electronic component 280 may include a battery connector electrically connected to the battery 189 (see FIG. 1).

Referring to FIG. 2C, power supplied from the battery 189 (see FIG. 1) may move along a first flow F1. For example, the power supplied from the battery 189 (see FIG. 1) may be supplied from the fourth electronic component 280 to the first electronic components 250 via the third electronic component 270 along the first flow F1. The first conductive plate 230 may electrically connect the first printed circuit board 210 and the second printed circuit board 220 so that the first flow F1 is formed.

Referring to FIG. 2C, power supplied to the first electronic components 250 may move along a second flow F2. For example, the power supplied to the first electronic components 250 may be supplied to the second electronic component 260 along the second flow F2. The second electronic component 260 may be driven using the power supplied from the first electronic components 250.

Referring to FIG. 2C, power supplied to the first electronic components 250 may move along a third flow F3. For example, the power supplied to the first electronic components 250 may be supplied along the third flow F3 to 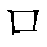 component required for operation of the electronic device 200 (e.g., a memory or a display).

In an embodiment, the first conductive plate 230 and the second conductive plate 290 may serve to electrically connect respective components of the electronic device 200. The first conductive plate 230 and the second conductive plate 290 may include a conductive material. For example, the first conductive plate 230 and the second conductive plate 290 may include stainless steel (STS).

In an embodiment, the first conductive plate 230 and the second conductive plate 290 may include a material that is not deformed in a reflow process.

In an embodiment, each of the first conductive plate 230 and the second conductive plate 290 may be manufactured by bending one object or may be manufactured by bonding a plurality of independent objects (e.g., conductive materials).

In an embodiment, conductors (e.g., conductive plates or conductive pads) of the electronic device 200 may be electrically connected to each other through soldering. For example, the first conductive plate 230 may be bonded to the first conductive pads 211 through soldering. The third conductive pads 212 may be bonded to the fourth conductive pads 222 through soldering.

In an embodiment, the printed circuit boards 210 and 220 may include a plurality of pads (e.g., the first conductive pads 211 and the second conductive pads 221) bonded to the first conductive plate 230 and the second conductive plate 290.

In an embodiment, bonding between conductors (e.g., the first conductive plate 230 and the first conductive pads 211) of the electronic device 200 may be performed using an automated surface mounting device (SMD).

In an embodiment, since the first conductive plate 230 is disposed on surfaces of the respective printed circuit boards 210 and 220 oriented in the same direction (e.g., the first surface 210A of the first printed circuit board 210 and the third surface 220A of the second printed circuit board 220), the first conductive plate 230 may be easily disposed using the automated surface mounting device (SMD).

In an embodiment, since the second conductive plate 290 is disposed on surfaces of the respective printed circuit boards 210 and 220 oriented in the same direction (e.g., the second surface 210B of the first printed circuit board 210 and the fourth surface 220B of the second printed circuit board 220), the second conductive plate 290 may be easily disposed using the automated surface mounting device (SMD).

In an embodiment, bonding between conductors (e.g., the first conductive plate 230 and the first conductive pads 211) of the electronic device 200 may be performed through manual soldering.

In an embodiment, when the conductive plates 230 and 290 are disposed on the printed circuit boards 210 and 220 through manual soldering, the conductive plates 230 and 290 may be disposed on surfaces of the respective printed circuit boards 210 and 220 oriented in different directions (e.g., the first surface 210A of the first printed circuit board 210 and the fourth surface 220B of the second printed circuit board 220).

In an embodiment, connection between the conductive plates 230 and 290 and pads of the printed circuit boards 210 and 220 may be implemented through a method other than soldering. For example, in an embodiment, connection between the conductive plates 230 and 290 and the printed circuit boards 210 and 220 may be implemented through bonding. In an embodiment, connection between the conductive plates 230 and 290 and the printed circuit boards 210 and 220 may be implemented in a form in which the conductive plates 230 and 290 are inserted into connection openings (not illustrated) formed in the printed circuit boards 210 and 220.

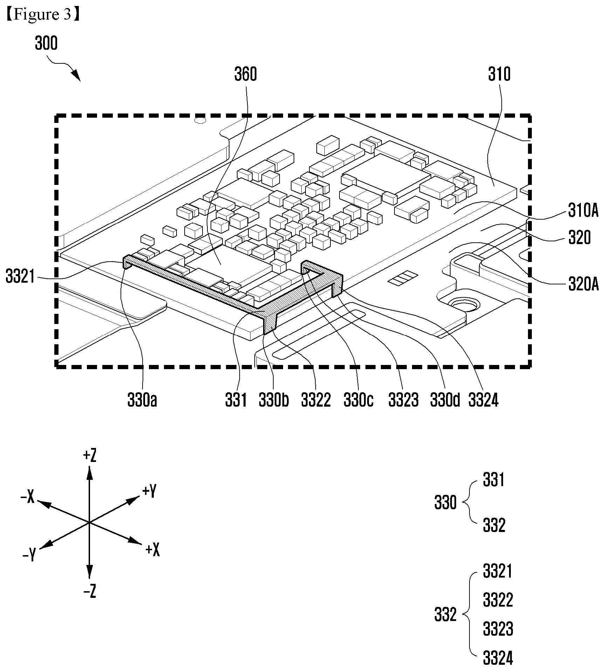

FIG. 3 is a view illustrating an electronic device 300 according to an embodiment of the disclosure.

The electronic device 300 of FIG. 3 may refer to the electronic device 200 of FIG. 2 or may include at least some of the components of the electronic device 200 of FIG. 2.

In describing the electronic device 300 according to an embodiment of the disclosure, the length direction of the electronic device 300 may refer to the X-axis direction, and the width direction of the electronic device 300 may refer to the Y-axis direction. The height direction of the electronic device 300 may refer to a Z-axis direction.

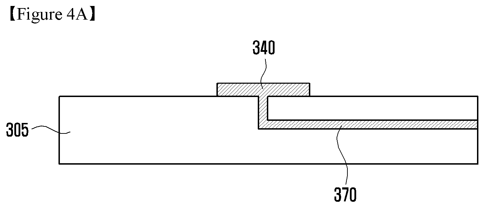

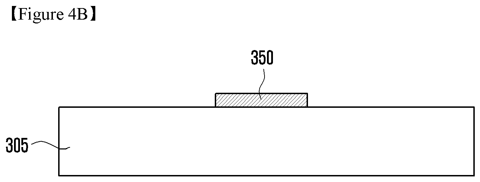

The electronic device 300 according to an embodiment of the disclosure may include a first printed circuit board 310, a second printed circuit board 320, a conductive plate 330, conductive pads 340 (see FIG. 4A), dummy pads 350 (see FIG. 4B), and/or an electronic component 360.

In an embodiment, the first printed circuit board 310 may have a configuration substantially the same as that of the first printed circuit board 210 of FIGS. 2A, 2B, and 2C. The second printed circuit board 320 may have a configuration substantially the same as that of the second printed circuit board 220 of FIGS. 2A, 2B, and 2C. The conductive plate 330 may have a configuration substantially the same as that of the first conductive plate 230 of FIGS. 2A, 2B, and 2C. The electronic component 360 may have a configuration substantially the same as that of the first electronic component 250 of FIGS. 2A, 2B, and 2C.

In describing the electronic device 300 of FIG. 3, detailed descriptions of configurations substantially the same as the configurations of the electronic device 200 illustrated in FIGS. 2A, 2B, and 2C may be omitted.

In an embodiment, the first printed circuit board 310 may be disposed on the second printed circuit board 320.

In an embodiment, the conductive plate 330 may be formed to include an "H" shape in at least a portion thereof. For example, the conductive plate 330 may include an "H" shape in at least a portion thereof and may be supported by the printed circuit boards 310 and 320 at four ends.

In an embodiment, the conductive plate 330 may be connected to the printed circuit boards 310 and 320 at four ends. For example, referring to FIG. 3, the conductive plate 330 may be connected to the printed circuit boards 310 and 320 at a first end 330a, a second end 330b, a third end 330c, and a fourth end 330d, respectively.

In an embodiment, when the conductive plate 330 is connected to the printed circuit boards 310 and 320 at four ends, the conductive plate 330 may be more stably supported by the printed circuit boards 310 and 320 than when the conductive plate 330 is connected to the printed circuit boards 310 and 320 at two ends. For example, when the conductive plate 330 is connected to the printed circuit boards 310 and 320 at four ends, the conductive plate 330 may be supported by the printed circuit boards 310 and 320 at the four ends, respectively, so that deformation of the conductive plate 330 due to an external force or a change in a disposition position of the conductive plate 330 during a reflow process may be prevented or reduced.

In an embodiment, at least some of the ends of the conductive plate 330 may not be electrically connected to the printed circuit boards 310 and 320. For example, the first end 330a and the second end 330b of the conductive plate 330 may be in contact with conductive pads 340 (see FIG. 4A) and electrically connected thereto, and the third end 330c and the fourth end 330d of the conductive plate 330 may be in contact with a dummy pad 350 (see FIG. 4B). The third end 330c and the fourth end 330d of the conductive plate 330, which are in contact with the dummy pad 350 (see FIG. 4B), may not be electrically connected to the printed circuit boards 310 and 320.

In an embodiment, a direction in which the first end 330a and the second end 330b are spaced apart from each other may not be substantially parallel to a direction in which the second end 330b and the third end 330c are spaced apart from each other. For example, referring to FIG. 3, the first end 330a may be spaced apart from the second end 330b in the length direction of the electronic device 300 (e.g., the X-axis direction). The third end 330c may be spaced apart from the second end 330b in the width direction of the electronic device 300 (e.g., the Y-axis direction).

In an embodiment, the first end 330a and the second end 330b may be spaced apart from each other in the height direction of the electronic device 300 (e.g., the Z-axis direction) and the length direction of the electronic device 300 (e.g., the X-axis direction).

In an embodiment, the conductive plate 330 may include a horizontal region 331 and/or a vertical region 332.

In an embodiment, the horizontal region 331 may be a region of the conductive plate 330 extending substantially parallel to one surface 310A or 320A of the printed circuit board 310 or 320.

In an embodiment, the vertical region 332 may be a region of the conductive plate 330 extending substantially perpendicular to one surface 310A or 320A of the printed circuit board 310 or 320.

In an embodiment, the conductive plate 330 may include four vertical regions 332. For example, the vertical regions 332 may include a first vertical region 3321, a second vertical region 3322, a third vertical region 3323, and a fourth vertical region 3324.

In an embodiment, two vertical regions 332 among the four vertical regions 332 may extend from the horizontal region 331 toward the first printed circuit board 310, and the remaining two vertical regions 332 may extend from the horizontal region 331 toward the second printed circuit board 320. For example, the first vertical region 3321 and the third vertical region 3323 may extend toward the first printed circuit board 310, and the second vertical region 3322 and the fourth vertical region 3324 may extend toward the second printed circuit board 320.

Although FIG. 3 illustrates that the conductive plate 330 is in contact with the printed circuit boards 310 and 320 at four ends, the shape of the conductive plate 330 may not be limited thereto. For example, in an embodiment, the conductive plate 330 may be in contact with the printed circuit boards 310 and 320 at five or more ends.

FIGS. 4A and 4B are views respectively illustrating a conductive pad 340 and a dummy pad 350 according to an embodiment of the disclosure.

FIG. 4A is a view illustrating a conductive pad 340 according to an embodiment. FIG. 4B is a view illustrating a dummy pad 350 according to an embodiment.

The printed circuit board 305 illustrated in FIGS. 4A and 4B may include the first printed circuit board 310 of FIG. 3 and/or the second printed circuit board 320 of FIG. 3.

Referring to FIG. 4A, the conductive pad 340 may be formed on the printed circuit board 305.

In an embodiment, the conductive pad 340 may be connected to wiring 370 extending through the inside of the printed circuit board 305. The wiring 370 may serve to electrically connect the conductive pad 340 and the printed circuit board 305.

Referring to FIG. 4B, the dummy pad 350 may be formed on the printed circuit board 305. The dummy pad 350 may not be connected to the wiring 370.

In an embodiment, the dummy pad 350 may be a pad formed on one surface of the printed circuit board 305 and not electrically connected to the printed circuit board 305. In an embodiment, the dummy pad 350 may be an electrically non-polar pad.

In an embodiment, the dummy pad 350 may be a pad disposed to support the conductive plate 330 (see FIG. 3). For example, the dummy pad 350 may be a pad that is not electrically connected to the printed circuit board 305 and is disposed on the printed circuit board 305 to support the conductive plate 330 (see FIG. 3).

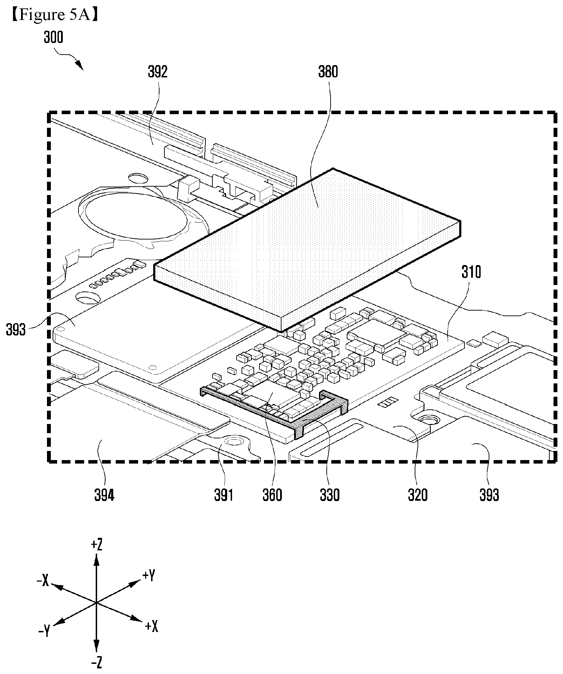

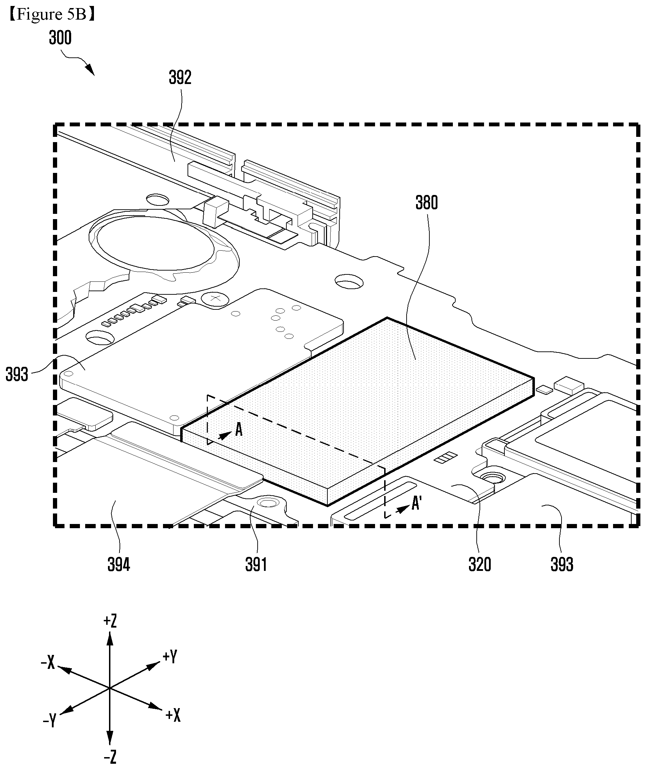

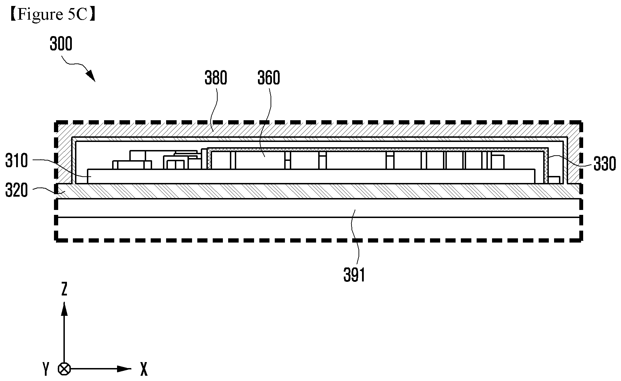

FIGS. 5A, 5B, and 5C are views illustrating an electronic device 300 according to an embodiment of the disclosure.

FIG. 5A is a view illustrating printed circuit boards 310 and 320 and a shield can 380 according to an embodiment. FIG. 5B is a view illustrating the second printed circuit board 320 on which the shield can 380 according to an embodiment is disposed. FIG. 5C is a cross-sectional view illustrating the electronic device 300 viewed along line A-A' of FIG. 5B.

Referring to FIG. 5A, the electronic device 300 according to an embodiment may include the first printed circuit board 310, the second printed circuit board 320, the conductive plate 330, an electronic component 360, a first shield can 380, a support member 391, a side member 392, a second shield can 393, and/or a connector 394.

In an embodiment, at least some of the components of the electronic device 300 may be disposed on the support member 391. For example, in an embodiment, the printed circuit boards 310 and 320 may be disposed on the support member 391.

In an embodiment, the side member 392 may be disposed substantially perpendicular to the support member 391. The side member 392 may be disposed to surround at least some of the components of the electronic device 300.

In an embodiment, the first shield can 380 may be disposed to surround the first printed circuit board 310. The second shield can 393 may be disposed to surround electronic components disposed on the second printed circuit board 320.

In an embodiment, the connector 394 may serve to electrically connect the second printed circuit board 320 to another component of the electronic device 300.

In an embodiment, the first shield can 380 may be disposed to surround an outer periphery of the first printed circuit board 310. For example, referring to FIGS. 5A, 5B, and 5C, the first shield can 380 may be disposed on the second printed circuit board 320 to surround the first printed circuit board 310.

In an embodiment, the first shield can 380 may be disposed to surround the conductive plate 330. For example, referring to FIGS. 5A, 5B, and 5C, the first shield can 380 may be disposed on the second printed circuit board 320 to surround the conductive plate 330.

In an embodiment, the first shield can 380 may serve to shield noise radiated from the first printed circuit board 310 and the conductive plate 330.

In an embodiment, the conductive plate 330 may be disposed on the first printed circuit board 310 and the second printed circuit board 320. The conductive plate 330 may serve to electrically connect the first printed circuit board 310 and the second printed circuit board 320.

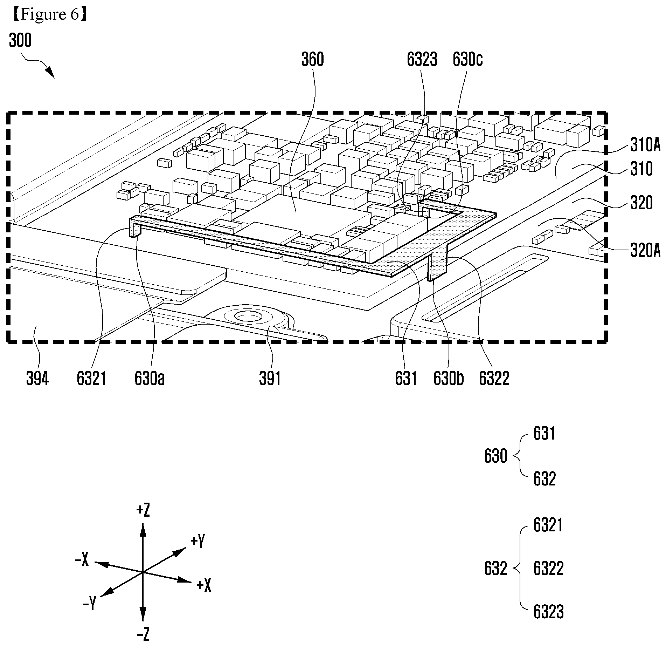

FIG. 6 is a view illustrating the electronic device 300 including a conductive plate 630 according to an embodiment of the disclosure.

In an embodiment, the conductive plate 630 may include a horizontal region 631 and/or a vertical region 632.

In an embodiment, the horizontal region 631 may be a region of the conductive plate 630 extending substantially parallel to one surface 310A or 320A of the printed circuit board 310 or 320.

In an embodiment, the vertical region 632 may be a region of the conductive plate 630 extending substantially perpendicular to one surface 310A or 320A of the printed circuit board 310 or 320.

In an embodiment, the conductive plate 630 may include three vertical regions 632. For example, the vertical regions 632 may include a first vertical region 6321, a second vertical region 6322, and a third vertical region 6323.

In an embodiment, two vertical regions 632 among the three vertical regions 632 may extend from the horizontal region 631 toward the first printed circuit board 310, and the remaining one vertical regions 632 may extend from the horizontal region 631 toward the second printed circuit board 320. For example, the first vertical region 6321 and the third vertical region 6323 may extend toward the first printed circuit board 310, and the second vertical region 6322 may extend toward the second printed circuit board 320.

In an embodiment, the conductive plate 630 may be supported by the printed circuit boards 310 and 320 at three ends. For example, referring to FIG. 6, the conductive plate 630 may be supported by the printed circuit boards 310 and 320 at a first end 630a, a second end 630b, and a third end 630c, respectively.

In an embodiment, the conductive plate 630 may be formed such that the three ends are not located on the same imaginary straight line. For example, an imaginary straight line passing through the first end 630a and the second end 630b and the third end 630c may be spaced apart from each other.

In an embodiment, one of the three ends of the conductive plate 630 may be in contact with the dummy pad 350 (see FIG. 4B). For example, the first end 630a and the second end 630b of the conductive plate 630 may be in contact with conductive pads 340 (see FIG. 4A), and the third end 630c of the conductive plate 630 may be in contact with a dummy pad 350 (see FIG. 4B).

In an embodiment, when the conductive plate 630 is connected to the printed circuit boards 310 and 320 at three ends, the conductive plate 630 may be more stably supported by the printed circuit boards 310 and 320 than when the conductive plate 330 is connected to the printed circuit boards 310 and 320 at two ends. For example, when the conductive plate 630 is connected to the printed circuit boards 310 and 320 at three ends, the conductive plate 630 may be supported by the printed circuit boards 310 and 320 at the three ends, respectively, so that deformation of the conductive plate 630 due to an external force or a change in a disposition position of the conductive plate 630 during a reflow process may be prevented or reduced.

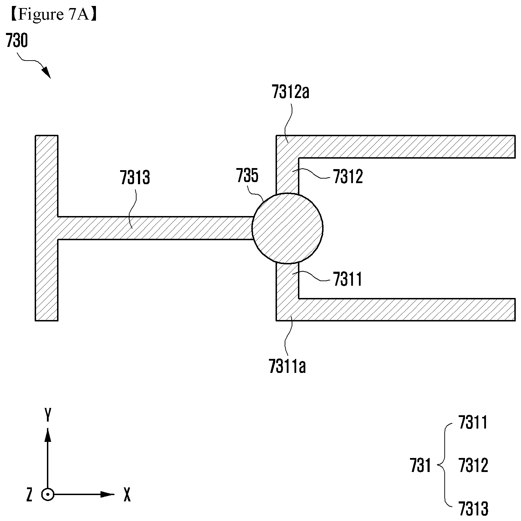

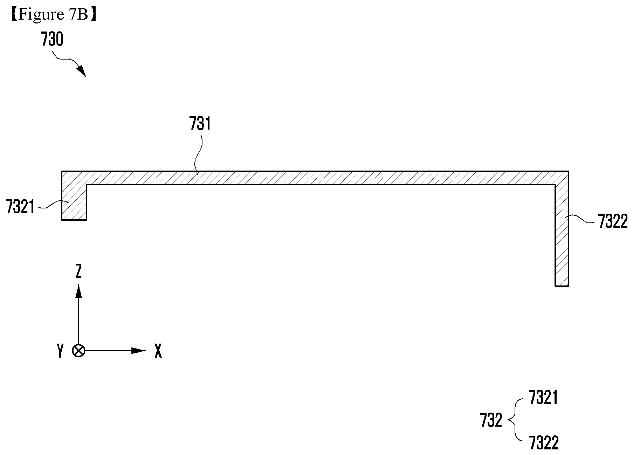

FIGS. 7A and 7B are views illustrating a conductive plate 730 according to an embodiment of the disclosure.

FIG. 7A is a plan view illustrating the conductive plate 730 according to an embodiment. FIG. 7B is a front view illustrating the conductive plate 730 according to an embodiment.

In describing the conductive plate 730 according to an embodiment of the disclosure, the length direction of the conductive plate 730 may refer to the X-axis direction, and the width direction may refer to the Y-axis direction. The height direction of the conductive plate 730 may refer to the Z-axis direction.

The conductive plate 730 of FIGS. 7A and 7B may include at least a portion of the first conductive plate 230 of FIGS. 2A, 2B, and 2C.

In an embodiment, the conductive plate 730 may include a horizontal region 731, a vertical region 732, and/or a seating portion 735.

In an embodiment, the conductive plate 730 may be bonded to the printed circuit boards 310 and 320 (see FIG. 3) by soldering using a surface mounting device (SMD).

In an embodiment, the seating portion 735 may be a portion on which an external nozzle (not illustrated) for disposing the conductive plate 730 on the printed circuit boards 310 and 320 (see FIG. 3) is seated. For example, the external nozzle (not illustrated) may be seated on the seating portion 735, may suction the conductive plate 730, and may move the conductive plate 730 to a predetermined position.

In an embodiment, the external nozzle (not illustrated) may be configured to suction the conductive plate 730 through air suction.

In an embodiment, when the conductive plate 730 includes the seating portion 735, the conductive plate 730 may be more easily disposed at a predetermined position. For example, since the external nozzle (not illustrated) may be seated on the seating portion 735 and suction the conductive plate 730, it may be easy to move the conductive plate 730 to the predetermined position.

In an embodiment, the seating portion 735 may be formed in a shape corresponding to the external nozzle (not illustrated). For example, when the external nozzle (not illustrated) is formed in a circular shape, the seating portion 735 may have a circular shape corresponding to the external nozzle (not illustrated).

In an embodiment, the seating portion 735 may be formed to have different sizes based on the weight of the conductive plate 730 and/or the size of the external nozzle (not illustrated). For example, as the weight of the conductive plate 730 increases, the seating portion 735 may be formed larger. As the size of the external nozzle (not illustrated) increases, the seating portion 735 may be formed larger.

In an embodiment, the seating portion 735 may be formed larger than the external nozzle (not illustrated). For example, when the seating portion 735 is formed in a circular shape, the diameter of the seating portion 735 may be greater than the diameter of the external nozzle (not illustrated).

In an embodiment, when the seating portion 735 is formed larger than the external nozzle (not illustrated), the external nozzle (not illustrated) may be more easily seated on the seating portion 735.

In an embodiment, the horizontal region 731 of the conductive plate 730 may be a region extending substantially parallel to a printed circuit board (e.g., the printed circuit board 310 or 320 of FIG. 3). The horizontal region 731 may extend substantially parallel to the length direction (e.g., the X-axis direction) and the width direction (e.g., the Y-axis direction) of the conductive plate 730.

In an embodiment, the horizontal region 731 may include a first horizontal region 7311, a second horizontal region 7312, and/or a third horizontal region 7313.

In an embodiment, the first horizontal region 7311, the second horizontal region 7312, and the third horizontal region 7313 may be connected to the seating portion 735.

In an embodiment, the first horizontal region 7311, the second horizontal region 7312, and the third horizontal region 7313 may extend from the seating portion 735 in different directions.

In an embodiment, the horizontal region 731 may extend while being curved at least in part. For example, referring to FIG. 7A, the first horizontal region 7311 may extend while being curved in a first bending region 7311a. The second horizontal region 7312 may extend while being curved in a second bending region 7312a.

In an embodiment, the vertical region 732 of the conductive plate 730 may be a region extending substantially perpendicular to a printed circuit board (e.g., the printed circuit board 310 or 320 of FIG. 3). The vertical region 732 may extend substantially parallel to the height direction of the conductive plate 730 (e.g., the Z-axis direction).

In an embodiment, the conductive plate 730 may include a plurality of vertical regions 732. For example, the vertical regions 732 may include a first vertical region 7321 and/or a second vertical region 7322.

In an embodiment, the first vertical region 7321 may be a region extending from the horizontal region 731 toward the first printed circuit board 310 (see FIG. 3). The second vertical region 7322 may be a region extending from the horizontal region 731 toward the second printed circuit board 320 (see FIG. 3).

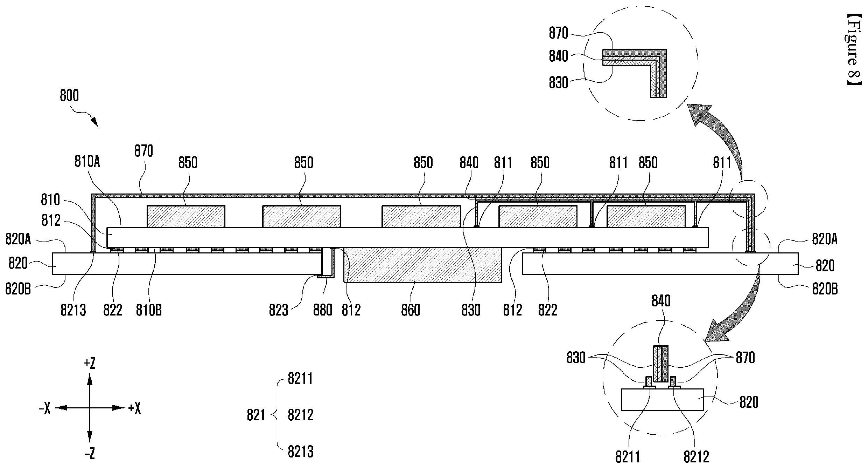

FIG. 8 is a view illustrating an electronic device 800 according to an embodiment of the disclosure.

The electronic device 800 of FIG. 8 may include at least some of the components of the electronic device 200 of FIGS. 2A, 2B, and 2C.

The electronic device 800 according to an embodiment of the disclosure may include a first printed circuit board 810, a second printed circuit board 820, a first conductive plate 830, an insulator 840, a first electronic component 850, a second electronic component 860, a shield can 870, and/or a second conductive plate 880.

In describing the electronic device 800 according to an embodiment of the disclosure, the height direction of the electronic device 800 may refer to the Z-axis direction. The length direction of the electronic device 800 may refer to the X-axis direction.

In an embodiment, the first printed circuit board 810 may have a configuration substantially the same as that of the first printed circuit board 210 of FIGS. 2A, 2B, and 2C. The second printed circuit board 820 may have a configuration substantially the same as that of the second printed circuit board 220 of FIGS. 2A, 2B, and 2C. The first conductive plate 830 may have a configuration substantially the same as that of the first conductive plate 230 of FIGS. 2A, 2B, and 2C. The first electronic component 850 may have a configuration substantially the same as that of the first electronic component 250 of FIGS. 2A, 2B, and 2C. The second electronic component 860 may have a configuration substantially the same as that of the second electronic component 260 of FIGS. 2A, 2B, and 2C. The second conductive plate 880 may have a configuration substantially the same as that of the second conductive plate 290 of FIGS. 2A, 2B, and 2C.

In describing the electronic device 800 of FIG. 8, detailed descriptions of configurations substantially the same as configurations of the electronic device 200 illustrated in FIGS. 2A, 2B, and 2C may be omitted.

In an embodiment, the first printed circuit board 810 may include a first surface 810A, a second surface 810B, and/or first conductive pads 811.

In an embodiment, the second printed circuit board 820 may include a third surface 820A, a fourth surface 820B, and/or second conductive pads 821.

In an embodiment, the first surface 810A may be a surface of the first printed circuit board 810 oriented in the positive Z-axis direction. The second surface 810B may be a surface opposite to the first surface 810A. For example, the second surface 810B may be a surface of the first printed circuit board 810 oriented in the negative Z-axis direction.

In an embodiment, the second conductive pads 821 may be formed on the third surface 820A of the second printed circuit board 820. In an embodiment, at least a portion of the third surface 820A may face the second surface 810B.

In an embodiment, the shield can 870 may be disposed to surround the first printed circuit board 810. For example, the shield can 870 may be disposed on the second printed circuit board 820 to surround the first printed circuit board 810.

In an embodiment, the first conductive plate 830 and the shield can 870 may be integrally formed.

In an embodiment, when the first conductive plate 830 and the shield can 870 are integrally formed, both the first conductive plate 830 and the shield can 870 may be electrically connected to the printed circuit boards 810 and 820 through a single mounting process (e.g., a process using a surface mounting device).

In an embodiment, when the first conductive plate 830 and the shield can 870 are integrally formed, a process for manufacturing the first conductive plate 830 and the shield can 870 may be simplified, and manufacturing costs may be reduced.

In an embodiment, the first conductive plate 830 may be disposed on at least a portion of the surface of the shield can 870 facing the first printed circuit board 810.

In an embodiment, the insulator 840 may be disposed between the first conductive plate 830 and the shield can 870.

In an embodiment, the insulator 840 may be attached to the shield can 870 through coating.

In an embodiment, the insulator 840 may serve to prevent or reduce a short circuit between the first conductive plate 830 and the shield can 870. For example, the insulator 840 may serve to prevent or reduce a short circuit between the shield can 870 having an electrical characteristic as a ground and the first conductive plate 830 having an electrical characteristic as a signal line.

In an embodiment, the first conductive plate 830 may be fixed to the shield can 870 using an adhesive.

In an embodiment, the first conductive plate 830 may be coupled to the shield can 870 using a separate fixing structure (not illustrated) (e.g., a hook-shaped fixing structure).

In an embodiment, the insulator 840 disposed between the first conductive plate 830 and the shield can 870 may include an adhesive material. The first conductive plate 830 may be fixed to the shield can 870 using the insulator 840 including the adhesive material.

In an embodiment, the second conductive pad 821 may include a (2-1)^{th} conductive pad 8211, a (2-2)^{th} conductive pad 8212, and/or a (2-3)^{th} conductive pad 8213.

In an embodiment, the (2-1)^{th} conductive pad 8211 may be a pad in contact with an end of the first conductive plate 830. The (2-2)^{th} conductive pad 8212 may be a pad in contact with an end of the shield can 870 positioned adjacent to the first conductive plate 830. The (2-3)^{th} conductive pad 8213 may be a pad in contact with an end of the shield can 870 not positioned adjacent to the first conductive plate 830.

In an embodiment, the (2-1)^{th} conductive pad 8211 and the (2-2)^{th} conductive pad 8212 may be spaced apart from each other. The (2-1)^{th} conductive pad 8211 and the (2-2)^{th} conductive pad 8212 may be disposed with a distance therebetween, and a short circuit between the (2-1)^{th} conductive pad 8211 and the (2-2)^{th} conductive pad 8212 may be prevented or reduced.

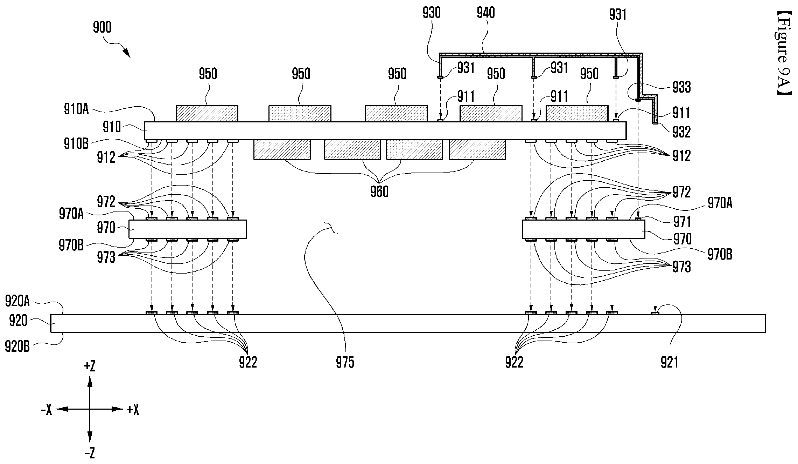

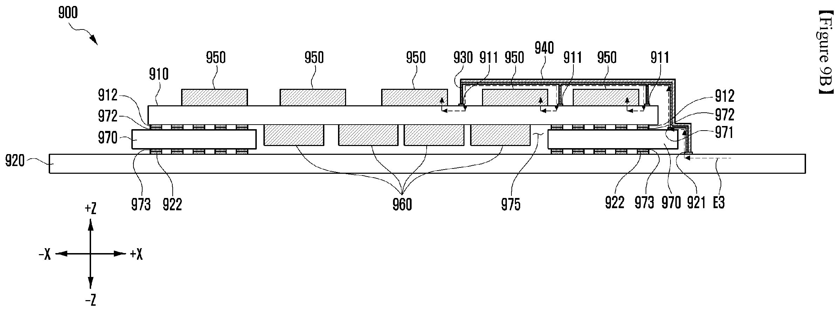

FIGS. 9A and 9B are views illustrating an electronic device 900 according to an embodiment of the disclosure.

FIG. 9A is a view illustrating a first printed circuit board 910, a second printed circuit board 920, and a third printed circuit board 970 according to an embodiment. FIG. 9B is a view illustrating an electronic device 900 including the third printed circuit board 970 according to an embodiment.

The electronic device 900 of FIGS. 9A and 9B may include at least some of the components of the electronic device 200 of FIGS. 2A, 2B, and 2C.

In describing the electronic device 900 according to an embodiment of the disclosure, the height direction of the electronic device 900 may refer to the Z-axis direction. The length direction of the electronic device 900 may refer to the X-axis direction.

The electronic device 900 according to an embodiment of the disclosure may include a first printed circuit board 910, a second printed circuit board 920, a conductive plate 930, an insulating member 940, a first electronic component 950, a second electronic component 960, and/or the third printed circuit board 970.

In an embodiment, the first printed circuit board 910 may have a configuration substantially the same as that of the first printed circuit board 210 of FIGS. 2A, 2B, and 2C. The second printed circuit board 920 may have a configuration substantially the same as that of the second printed circuit board 220 of FIGS. 2A, 2B, and 2C. The first electronic component 950 may have a configuration substantially the same as that of the first electronic component 250 of FIGS. 2A, 2B, and 2C. The second electronic component 960 may have a configuration substantially the same as that of the second electronic component 260 of FIGS. 2A, 2B, and 2C.

In describing the electronic device 900 of FIGS. 9A and 9B, detailed descriptions of configurations substantially the same as the configurations of the electronic device 200 illustrated in FIGS. 2A, 2B, and 2C may be omitted.

The dashed arrows illustrated in FIG. 9A may indicate directions in which components of the electronic device 900 are moved and disposed. For example, the first printed circuit board 910, the third printed circuit board 970, and the conductive plate 930 may be moved and disposed along the directions illustrated by the dashed arrows.

In an embodiment, the first printed circuit board 910 may include a first surface 910A, a second surface 910B, first conductive pads and/or third conductive pads 912.

In an embodiment, the second printed circuit board 920 may include a third surface 920A, a fourth surface 920B, a second conductive pad 921 and/or fourth conductive pads 922.

In an embodiment, the third printed circuit board 970 may include a fifth surface 970A, a sixth surface 970B, a fifth conductive pad 971, sixth conductive pads 972 and/or seventh conductive pads 973.

In an embodiment, the third printed circuit board 970 may be disposed between the first printed circuit board 910 and the second printed circuit board 920.

In an embodiment, at least a portion of the fifth surface 970A may face the second surface 910B.

In an embodiment, the third printed circuit board 970 may be disposed between the first printed circuit board 910 and the second printed circuit board 920 such that the sixth conductive pads 972 are in contact with the third conductive pads 912.

In an embodiment, the third printed circuit board 970 may be disposed between the first printed circuit board 910 and the second printed circuit board 920 such that the seventh conductive pads 973 are in contact with the fourth conductive pads 922.

In an embodiment, the conductive plate 930 may be at least partially disposed on the first surface 910A of the first printed circuit board 910, the third surface 920A of the second printed circuit board 920, and the fifth surface 970A of the third printed circuit board 970.

Referring to FIG. 9B, a third power flow E3 from an upper surface of the second printed circuit board 920 (e.g., the third surface 920A) toward an upper surface of the first printed circuit board 910 (e.g., the first surface 910A) may be formed along the conductive plate 930.

In an embodiment, the conductive plate 930 may include first plate pads 931, a second plate pad 932, and/or a third plate pad 933 disposed at ends thereof.

In an embodiment, the first plate pad 931 may be in contact with the first conductive pads 911. The second plate pad 932 may be in contact with the second conductive pad 921. The third plate pad 933 may be in contact the fifth conductive pad 971.

In an embodiment, the insulating member 940 may be disposed on at least a portion of the conductive plate 930. In an embodiment, the insulating member 940 may include an insulating material.

In an embodiment, the insulating member 940 may serve to prevent the conductive plate 930 from being electrically exposed. For example, the insulating member 940 may serve to prevent or reduce an electrical shock that may be applied to the conductive plate 930.

In an embodiment, the first printed circuit board 910, the second printed circuit board 920, and the third printed circuit board 970 may be electrically connected to each other through the conductive plate 930. For example, referring to FIGS. 9A and 9B, each of the first surface 910A of the first printed circuit board 910, the third surface 920A of the second printed circuit board 920, and the fifth surface 970A of the third printed circuit board 970 may be in contact with the conductive plate 930, and the first printed circuit board 910, the second printed circuit board 920, and the third printed circuit board 970 may be electrically connected to each other through the conductive plate 930.

The conductive plate 930 may be disposed on the printed circuit boards 910, 920, and 970 in a form different from that illustrated in FIGS. 9A and 9B. For example, in an embodiment, each of the second surface 910B of the first printed circuit board 910, the fourth surface 920B of the second printed circuit board 920, and the sixth surface 970B of the third printed circuit board 970 may be in contact with the conductive plate 930, so that the respective printed circuit boards 910, 920, and 970 may be electrically connected to each other. In this case, the second printed circuit board 920 may include an opening (not illustrated) in which the conductive plate 930 may be disposed.

In an embodiment, the third printed circuit board 970 may include an opening 975 in at least a portion thereof.

In an embodiment, the second electronic component 960 may be inserted into the opening 975 of the third printed circuit board 970.

In an embodiment, the conductive plate 930 may be disposed so as not to be in contact with some of the three printed circuit boards 910, 920, and 970. For example, the conductive plate 930 according to an embodiment may be disposed to be in contact with the first printed circuit board 910 and the second printed circuit board 920 and not to be in contact with the third printed circuit board 970.

Although FIGS. 9A and 9B illustrate that the three printed circuit boards 910, 920, and 970 are stacked, the number of stacked printed circuit boards 910, 920, and 970 may not be limited thereto. For example, in an embodiment, the electronic device 900 may include a structure in which four or more printed circuit boards 910, 920, and 970 are stacked. In this case, the conductive plate 930 may be disposed to be in contact with all of the four or more stacked printed circuit boards 910, 920, and 970, or may be disposed to be in contact with some of the four or more stacked printed circuit boards 910, 920, and 970.

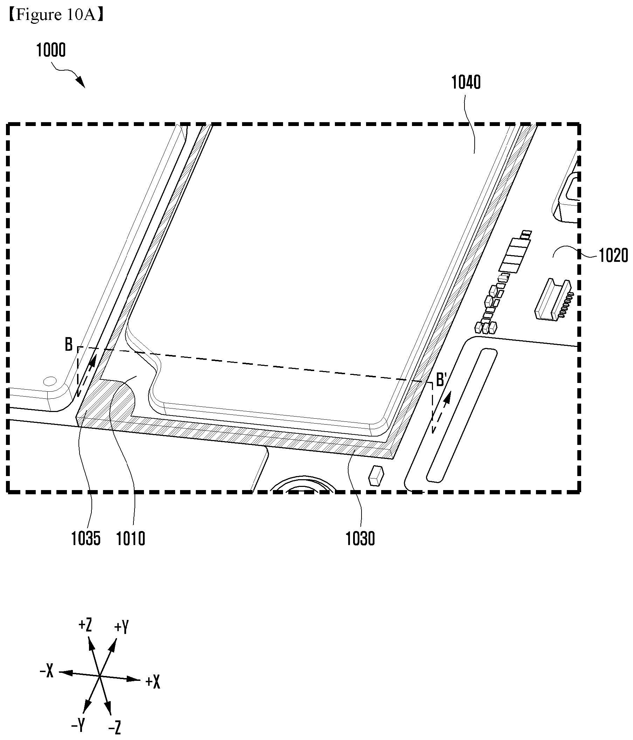

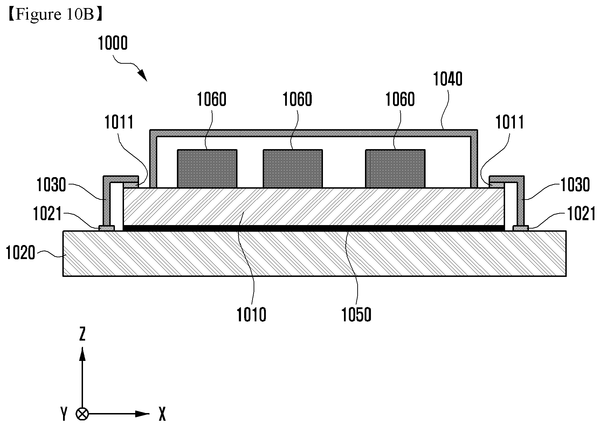

FIGS. 10A and 10B are views illustrating an electronic device 1000 according to an embodiment of the disclosure.

FIG. 10A is a view illustrating an electronic device 1000 including a shield plate 1030 according to an embodiment. FIG. 10B is a cross-sectional view illustrating the electronic device 1000 taken along line B-B' of FIG. 10A.

The electronic device 1000 of FIGS. 10A and 10B may include at least some of the components of the electronic device 200 of FIGS. 2A, 2B, and 2C.

Referring to FIGS. 10A and 10B, the electronic device 1000 according to an embodiment may include a first printed circuit board 1010, a second printed circuit board 1020, a shield plate 1030, a shield can 1040, a bonding portion 1050, and/or electronic components 1060.

In an embodiment, the first printed circuit board 1010 may be disposed on the second printed circuit board 1020.

Referring to FIG. 10B, the first printed circuit board 1010 may be bonded to the second printed circuit board 1020 via the bonding portion 1050.

In an embodiment, the electronic components 1060 may be disposed on the first printed circuit board 1010.

In an embodiment, the electronic components 1060 may include components (e.g., the processor 120 of FIG. 1 or the memory 130 of FIG. 1) required for operation of the electronic device 1000. In an embodiment, the electronic components 1060 may include the first electronic component 250 and/or the second electronic component 260 of FIGS. 2A, 2B, and 2C.

In an embodiment, the shield can 1040 may be disposed on the first printed circuit board 1010.

In an embodiment, the shield can 1040 may be disposed to surround the electronic components 1060. The shield can 1040 may serve to shield noise radiated from the electronic components 1060.

Referring to FIGS. 10A and 10B, the shielding plate 1030 according to an embodiment may be formed to extend along an outer periphery of the first printed circuit board 1010.

In an embodiment, the shield plate 1030 may be disposed to surround the bonding portion 1050.

In an embodiment, the shield plate 1030 may be spaced apart from the shield can 1040. For example, the shield plate 1030 may be disposed with a distance from a periphery of the shield can 1040.

Referring to FIG. 10B, the first printed circuit board 1010 may include first pads 1011 formed on one surface thereof. The second printed circuit board 1020 may include second pads 1021 formed on one surface thereof. The shielding plate 1030 may be in contact with the first pads 1011 at one end and may be in contact the second pad 1021 at the other end.

In an embodiment, the shield plate 1030 may include a conductive material. For example, the shielding plate 1030 may include stainless steel (STS).

In an embodiment, the shielding plate 1030 may serve to shield noise radiated from the bonding portion 1050.

In an embodiment, the shielding plate 1030 may serve as a ground of the printed circuit boards 1010 and 1020.

In an embodiment, the shielding plate 1030 may include a seating portion 1035 configured allow an external nozzle (not illustrated) to be seated thereon.

In an embodiment, the seating portion 1035 of the shield plate 1030 may be formed larger than an external nozzle (not illustrated). For example, the width of the seating portion 1035 of the shield plate 1030 may be greater than the diameter of the external nozzle (not illustrated). The width of the seating portion 1035 of the shield plate 1030 may refer to a length by which the seating portion 1035 of the shield plate 1030 extends in the length direction (e.g., the X-axis direction) or the width direction (e.g., the Y-axis direction) of the electronic device 1000.

In an embodiment, when the width of the seating portion 1035 is greater than the diameter of the external nozzle (not illustrated), the external nozzle (not illustrated) may be more easily seated on the seating portion 1035.

A printed circuit board having a high density of electronic components and wiring may be more vulnerable to high-temperature warpage occurring in a manufacturing process as the size of the printed circuit board increases. Accordingly, in a situation in which the size of the printed circuit board is limited, a structure for efficiently disposing electronic components and wiring may be required.

In a printed circuit board having a high density of wiring, the wiring may be formed such that a specific pin of an electronic component is connected to a specific pin of an adjacent printed circuit board at the shortest distance. However, when a specific pin of the electronic component is required to be connected to a pin other than the specific pin of the adjacent printed circuit board, wiring inside the printed circuit board is required to be long, and thus waste of wiring space may occur.

In a multilayer printed circuit board, for electrical connection between a first printed circuit board (e.g., a core printed circuit board) and a second printed circuit board (e.g., a master printed circuit board), wiring may extend through an inside of the first printed circuit board and may be connected to the second printed circuit board. However, since electronic components requiring connection of wiring in the first printed circuit board are distributed in various places, waste of wiring space may occur.

According to an embodiment of the disclosure, an electronic device 200, 300, 800, 900, or 1000 may include a first printed circuit board 210, 310, 810, 910, or 1010, a second printed circuit board 220, 320, 820, 920, or 1020, a power management circuit (e.g., the first electronic components 250 of FIG. 2C), a power supply circuit (e.g., the third electronic component 270 of FIG. 2C), a conductive plate 230, 330, 830, or 930, and an insulating member 240 or 940.

In an embodiment, the first printed circuit board 210 may include a first surface 210A, a second surface 210B opposite to the first surface 210A, and a first conductive pad 211 formed on the first surface 210A.

In an embodiment, the second printed circuit board 220 may include a third surface 220A, at least a portion of which faces the second surface 210B, a fourth surface 220B opposite to the third surface 220A, and a second conductive pad 221 formed on the third surface 220A.

In an embodiment, the power management circuit (e.g., the first electronic components 250 of FIG. 2C) may be disposed on the first surface 210A of the first printed circuit board 210 and may be electrically connected to the first conductive pad 211.

In an embodiment, the power supply circuit (e.g., the third electronic component 270 of FIG. 2C) may be disposed on at least one of the third surface 220A and the fourth surface 220B of the second printed circuit board 220 and may be electrically connected to the second conductive pad 221.

In an embodiment, the conductive plate 230 may include a first end 230a and a second end 230b.

In an embodiment, the conductive plate 230 may be in contact with the first conductive pad 211 at the first end 230a and may be in contact with the second conductive pad 221 at the second end 230b.

In an embodiment, the insulating member 240 may be disposed on at least a portion of the conductive plate 230.

In an electronic device 200, 300, 800, or 900 according to an embodiment of the disclosure, an upper surface (e.g., the first surface 210A) of a first printed circuit board 210 and an upper surface (e.g., the third surface 220A) of a second printed circuit board 220 may be electrically connected using a conductive plate (e.g., the first conductive plate 230).

In the electronic device 200, 300, 800, or 900 according to an embodiment of the disclosure, a lower surface (e.g., the second surface 210B) of the first printed circuit board 210 and a lower surface (e.g., the fourth surface 220B) of the second printed circuit board 220 may be electrically connected using a conductive plate (e.g., the second conductive plate 290).

In the electronic device 200, 300, 800, or 900 according to an embodiment of the disclosure, the first printed circuit board 210 and the second printed circuit board 220 may be electrically connected using the conductive plate 230, so that wiring extending through the inside of the first printed circuit board 210 and the second printed circuit board 220 may not be required.

In the electronic device 200, 300, 800, or 900 according to an embodiment of the disclosure, unnecessary wiring inside the printed circuit board may be removed, thereby improving a degree of freedom of wiring disposed on the printed circuit board and reducing a size of the printed circuit board.

In the electronic device 200, 300, 800, or 900 according to an embodiment of the disclosure, the number of pins of a bonding portion of a multilayer printed circuit board may be reduced.

In the electronic device 200, 300, 800, or 900 according to an embodiment of the disclosure, the conductive plate may be disposed using a surface mounting device (SMD) without a separate electrical component assembly process, so that respective printed circuit boards may be electrically connected.

In the electronic device 200, 300, 800, or 900 according to an embodiment of the disclosure, unnecessary wiring inside the printed circuit board may be removed, so that high-temperature warpage of the printed circuit board may be reduced.

In an embodiment, the electronic device 200 may include a processor (e.g., the second electronic component 260 of FIG. 2C) disposed on the second surface 210B of the first printed circuit board 210 and supplied with power from the power management circuit (e.g., the third electronic component 270 of FIG. 2C).

In an embodiment, the second printed circuit board 220 may include an opening 225 into which at least a portion of the processor (e.g., the second electronic component 260 of FIG. 2C) is inserted.

In an embodiment, the conductive plate 730 may include a seating portion 735 configured to allow an external nozzle to be seated thereon, and a diameter of the seating portion 735 may be greater than a diameter of the external nozzle.

In an embodiment, the electronic device 200 may include a dummy pad 350 formed on at least one of the first surface 210A or 310A of the first printed circuit board 210 or 310 and the third surface 220A or 320A of the second printed circuit board 220 or 320.

In an embodiment, the conductive plate 330 may be in contact with the first conductive pad 211 or 340 at the first end 330a, may be in contact with the second conductive pad 221 or 340 at the second end 330b, and may be in contact with the dummy pad 350 at a remaining end.

In an embodiment, the electronic device may include a shield can 380 or 870 disposed on the second printed circuit board 320 or 820 to surround the first printed circuit board 310 or 810.

In an embodiment, the conductive plate 830 may be disposed on at least a portion of a surface of the shield can 870 facing the first printed circuit board 810.

In an embodiment, the electronic device 800 may include an insulator 840 disposed between the conductive plate 830 and the shield can 870.

In an embodiment, the second conductive pad 821 may include a third conductive pad (e.g., the (2-1)^{thth} conductive pad 8211) in contact with an end of the conductive plate 830 (e.g., the second end 230b), and a fourth conductive pad (e.g., the (2-2)^{th} conductive pad 8212) in contact with an end of the shield can 870.

In an embodiment, the third conductive pad (e.g., the (2-1)^{th} conductive pad 8211) and the fourth conductive pad (e.g., the (2-2)^{th} conductive pad 8212) may be spaced apart from each other.

In an embodiment, the electronic device 1000 may include a bonding portion 1050 disposed between the first printed circuit board 1010 and the second printed circuit board 1020 and connecting the first printed circuit board 1010 and the second printed circuit board 1020 to each other, and a shield plate 1030 configured to shield noise radiated from the bonding portion 1050.

In an embodiment, the shield plate 1030 may be formed to extend along an outer periphery of the first printed circuit board 1010.

In an embodiment, the shield plate 1030 may include a seating portion 1035 configured to allow an external nozzle to be seated thereon.

In an embodiment, the width of the seating portion 1035 of the shield plate 1030 may be greater than the diameter of the external nozzle.

The electronic device 1000 according to an embodiment of the disclosure may include the shield plate 1030 surrounding the bonding portion 1050, thereby shielding noise radiated from the bonding portion 1050.

In an embodiment, the electronic device 900 may include a third printed circuit board 970 disposed between the first printed circuit board 910 and the second printed circuit board 920 and including a fifth surface 970A, at least a portion of which faces the second surface 910B, and a sixth surface 970B opposite to the fifth surface 970A.

In an embodiment, the conductive plate 930 may be at least partially disposed on the first surface 910A of the first printed circuit board 910, the third surface 920A of the second printed circuit board 920, and the fifth surface 970A of the third printed circuit board 970.

In an embodiment, the power management circuit (e.g., the first electronic components 250 of FIG. 2C) may be configured to receive power from the power supply circuit (e.g., the third electronic component 270 of FIG. 2C) and to supply power to at least one electronic component (e.g., a memory or a display).

The electronic device 200, 300, 800, 900, or 1000 according to an embodiment of the disclosure may include a first printed circuit board 210, 310, 810, 910, or 1010, a second printed circuit board 220, 320, 820, 920, or 1020, a conductive plate 230, 330, 830, or 930, and an insulating member 240 or 940.

The technical subjects pursued in the disclosure may not be limited to the technical subjects mentioned above, and other technical subjects which are not mentioned herein may be clearly understood by those skilled in the art to which the disclosure pertains.

Advantageous effects obtainable from the disclosure are not limited to the effects mentioned above, and other effects which are not mentioned herein will be clearly understood by those skilled in the art to which the disclosure pertains.

An electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, or a home appliance. The electronic device according to an embodiment of the disclosure is not limited to those described above.

It should be appreciated that an embodiment of the disclosure and the terms used therein are not intended to limit the technological features set forth herein to particular embodiments and the disclosure includes various changes, equivalents, or alternatives for a corresponding embodiment. In relation to the description of the drawings, similar reference numerals may be used for similar or related components. The singular form of a noun corresponding to an item may include one item or a plurality of items unless the context clearly indicates otherwise. As used herein, each of such phrases as "A or B," "at least one of A and B," "at least one of A or B," "A, B, or C," at least one of A, B, and C,"and "at least one of A, B, or C," may include all possible combinations of the items enumerated together in a corresponding one of the phrases. Such terms as "a first", "a second", "the first", and "the second" may be used to simply distinguish a corresponding element from another, and does not limit the elements in other aspect (e.g., importance or order). When a certain (e.g., a first) component is mentioned as being "coupled" or "connected" to another (e.g., a second) component, with or without a term "functionally" or "communicatively," it means that the certain component may be connected to the other component directly (e.g., wiredly), wirelessly, or via a third component.

As used in an embodiment of the disclosure, the term "module" may include a unit implemented in hardware, software, or firmware, and may be interchangeably used with other terms, for example, "logic," "logic block," "component," or "circuit". The module may be an integrally configured component or a minimum unit or a portion of the component, which performs one or more functions. For example, according to an embodiment, the module may be implemented in the form of an application-specific integrated circuit (ASIC).

An embodiment of the disclosure may be implemented as software (e.g., the program 101) including one or more instructions that are stored in a storage medium (e.g., the internal memory 136 or external memory 138) that is readable by a machine (e.g., the electronic device 140). For example, a processor (e.g., the processor 120) of a device (e.g., the electronic device 101) may invoke and execute at least one of the stored one or more instructions from the storage medium. This enables the device to be operated to perform at least one function in response to the at least one invoked instruction. The one or more instructions may include codes generated by a compiler or code capable of being executed by an interpreter. The machine-readable storage medium may be provided in the form of a non-transitory storage medium. Here, the term "non-transitory" merely means that the storage medium is a tangible device and does not contain a signal (e.g., electromagnetic waves), and this term is not intended to distinguish a case where data is permanently stored on the storage medium and a case where data is temporarily stored.

According to an embodiment, a method according to various embodiments of the disclosure may be included and provided in a computer program product. The computer program product may be traded as a product between a seller and a purchaser. The computer program product may be distributed in the form of a machine-readable storage medium (e.g., a compact disc read-only memory (CD-ROM)), or may be directly distributed through an application store (e.g., Play Store^{™}) or directly between two user devices (e.g., smartphones), or may be distributed online (e.g., downloaded or uploaded). If distributed online, at least part of the computer program product may be temporarily stored or produced in a machine-readable storage medium such as a manufacturer's server, a server of an application store, or the memory of a relay server.

According to an embodiment, each component (e.g., a module or a program) of the above-described components may include a single entity or multiple entities, and some of the multiple entities may be separately disposed in different components. According to various embodiments, one or more of the components or operations described above may be omitted, or one or more other components or operations may be added. Alternatively, or additionally, multiple components (e.g., modules or programs) may be integrated into a single component. In such a case, the integrated element may perform one or more functions of each of the plurality of elements in the same or similar manner as they are performed by a corresponding one of the plurality of elements before the integration.

According to an embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device (200, 300, 800, 900, 1000) comprising:
a first printed circuit board (210, 310, 810, 910, 1010) including a first surface (210A), a second surface (210B) opposite to the first surface, and a first conductive pad (211) formed on the first surface;
a second printed circuit board (220, 320, 820, 920, 1020) including a third surface (220A), at least a portion of which faces the second surface of the first printed circuit board, a fourth surface (220B) opposite to the third surface, and a second conductive pad (221) formed on the third surface;
a conductive plate (230, 330, 830, 930) including a first end (230a) and a second end (230b), the conductive plate being in contact with the first conductive pad at the first end and being in contact with the second conductive pad at the second end; and
an insulating member (240, 940) disposed on at least a portion of the conductive plate.

2. The electronic device of claim 1, further comprising:
a power management circuit (250) disposed on the first surface of the first printed circuit board and electrically connected to the first conductive pad.

3. The electronic device of claim 2, further comprising:
a power supply circuit (270) disposed on at least one of the third surface and the fourth surface of the second printed circuit board and electrically connected to the second conductive pad.

4. The electronic device of claim 2, further comprising:
a processor (260) disposed on the second surface of the first printed circuit board and supplied with power from the power management circuit,
wherein the second printed circuit board includes an opening (225) into which at least a portion of the processor is inserted.

5. The electronic device of claim 4, wherein the conductive plate includes a seating portion (735) configured to allow an external nozzle to be seated thereon, and
wherein a diameter of the seating portion is greater than a diameter of the external nozzle.

6. The electronic device of claim 1, further comprising:
a dummy pad (350) formed on at least one of the first surface of the first printed circuit board and the third surface of the second printed circuit board,
wherein the conductive plate is in contact with the first conductive pad at the first end, is in contact with the second conductive pad at the second end, and is in contact with the dummy pad at a remaining end.

7. The electronic device of claim 1, further comprising:
a shield can (380, 870) disposed on the second printed circuit board to surround the first printed circuit board.

8. The electronic device of claim 7, wherein the conductive plate is disposed on at least a portion of a surface of the shield can facing the first printed circuit board.

9. The electronic device of claim 8, further comprising:
an insulator (840) disposed between the conductive plate and the shield can.

10. The electronic device of claim 8, wherein the second conductive pad includes:
a third conductive pad (8211) in contact with the second end of the conductive plate; and
a fourth conductive pad (8212) in contact with an end of the shield can, wherein the third conductive pad and the fourth conductive pad are spaced apart from each other.

11. The electronic device of claim 1, further comprising:
a bonding portion (1050) disposed between the first printed circuit board and the second printed circuit board and connecting the first printed circuit board and the second printed circuit board to each other; and
a shield plate (1030) configured to shield noise radiated from the bonding portion.

12. The electronic device of claim 11, wherein the shield plate extends along an outer periphery of the first printed circuit board.

13. The electronic device of claim 12, wherein the shield plate includes a seating portion (1035) configured to allow an external nozzle to be seated thereon, and
wherein a width of the seating portion of the shield plate is greater than a diameter of the external nozzle.

14. The electronic device of claim 1, further comprising:
a third printed circuit board (970) disposed between the first printed circuit board and the second printed circuit board and including a fifth surface (970A), at least a portion of which faces the second surface, and a sixth surface (970B) opposite to the fifth surface,
wherein the conductive plate is at least partially disposed on the first surface of the first printed circuit board, the third surface of the second printed circuit board, and the fifth surface of the third printed circuit board.

15. The electronic device of claim 3, wherein the power management circuit is configured to receive power from the power supply circuit and to supply power to at least one electronic component.
